# EUROPEAN PATENT APPLICATION

(11) **EP 2 249 427 A1**
(43) Date of publication of application: **10.11.2010**
(21) Application number: 08784091.4
(22) Date of filing: 22.08.2008
(51) Int. Cl.: H01M 10/48, G01R 31/36

(54) **A COLOR DISPLAY DEVICE FOR ELECTRIC QUANTITY OF BATTERY**

(30) Priority: 08.11.2007 CN 200710009787
(71) Applicant: Dai, Zengshi, Fujian 362000 (CN)
(72) Inventor: Dai, Zengshi, Fujian 362000 (CN)
(74) Representative: Hämmalov, Juhan
(86) International application number: PCT/CN2008/072100
(87) International publication number: WO 2009/059509

(57) **Abstract**

The present utility model provides a battery capacity chromogenic device that directly indicates the residual capacity of the lead acid battery. Said device comprises: a plurality of integrally formed indicating bars, fixing sleeves each provided on the upper end of respective indicating bars, supporting brackets each provided on the lower end of respective indicating bars, and color balls corresponding to the indicating bars in number, said supporting brackets are provided thereon with color ball passages corresponding to the indicating bars in number, said respective color ball passages are slantly disposed such that the vertical projections of the upper portions thereof and the vertical projections of the lower portions thereof are mutally staggered in the horizontal direction, and said respective color balls are increased in specific gravity successively and are respectively disposed in a certain order within said respective color ball passages. By disposing the color balls different in specific gravity below the plurality indicating bars in a certain order for a centralized indication, the current capacity of the battery is represented visually and accruately. The device is mainly used for indicating the capacity of the lead acid battery.

## Description

### Technical Field

The present invention relates to a lead acid battery assembly, in particular, to a battery capacity chromogenic device for indicating the residual capacity.

### Background Art

The lead acid battery is a low voltage direct current electrical source that is indispensable to various motor vehicles, which is composed of the positive and negative plates, membrane material, sulfuric acid and housing. Upon adding the sulfuric acid solution between the plates within the body of the housing, an electromotive force is generated inside the battery, the general reaction equation for the mutual conversion of the chemical energy and the electric energy thereof is PbO₂+2H⁺+2HSO₄-+Pb=2PhSO₄ + 2H₂O, from which it is seen that the magnitude of the electromotive force generated after adding the sulfuric acid into the battery depends on the solubility of H₂SO₄ in the solution. Upon discharging of the battery, the electrons are moving between the two electrodes to generate the electric current, while PbO₂ and Pb in the plates of the battery are gradually transformed into PhSO₄ and H₂O, thus, with the continuous discharging of the battery, the residual capacity thereof is increasingly reduced, as well as the H₂SO₄ in the solution, accordingly, the density of the solution is constantly lowered. On the contrary, upon charging of the battery, the PhSO₄ in the solution is continuously crystalized to precipitate PbO₂, Pb and H₂SO₄, thus solubility of H₂SO₄ in the solution is continuously increased, and the density of the solution is constantly raised, until being charged to the saturated state. According to this property, the Chinese patent No. CN2502414Y published on July 24, 2002 discloses a novel observable plastic piece, which consists of a indicating bar, a bar sleeve and color balls, etc.. The indicating bar is tightly wrapped with a fixing sleeve at the other end, the fixing sleeve is provided with male threads and the end face thereof is provided with a pair of bayonets, via which male thread, the indicating bar and the fixing sleeve is fastened to the battery box cover to avoid the direct contact of the indicating bar made of the PMMA plastic with the battery box cover, so as to extend its service life and lower the manufacturing cost. The Chinese patent No. CN2640051Y published on September 8, 2004 discloses an improved observable plastic piece, in which an intermediate bar sleeve and a bar cap are utilized to replace the previous transparent bar sleeve, through the tight coupling of the intermediate bar sleeve and the transparent indicating bar, the bar cap is detachably covered onto the intermediate bar sleeve, and two observation color balls with different colors are successively disposed between the inwardly depressed hollow chamber of the above described transparent indicating bar and the bar cap, whereby the liquid level and concentration of the electrolyte is known through observing the sinking and floating states of the color balls, so as to make the decision whether adding water or charing is required or not. Both of the afore-mentioned technical solutions can only roughly indicate the battery capacity, incapable of accurately judging the ratio of the current capacity of the battery to its total capacity, thus fail to determine whether the residual capacity of the battery is sufficient for the rest of the journey. Of course in some other cases using the lead acid batteries, it is also desired to have an indicating device via which the current capacity of the battery is visually known so as to decide whether charging should be carried out in time in order to fulfill a particular tast.

### Disclosure of the Invention

The object of the present utility model is to provide a battery capacity chromogenic device that directly indicates the residual capacity of the lead acid battery.

To achieve the above object, the technical solution adopted by the present utility model is as follows: a battery capacity chromogenic device, comprising: a plurality of integrally formed indicating bars, fixing sleeves each provided on the upper end of respective indicating bars, supporting brackets each provided on the lower end of respective indicating bars, and color balls corresponding to the indicating bars in number, said supporting brackets are provided thereon with color ball passages corresponding to the indicating bars in number, said respective color ball passages are slantly disposed such that the vertical projections of the upper portions thereof and the vertical projections of the lower portions thereof are mutally staggered in the horizontal direction, and said respective color balls are increased in specific gravity successively and are respectively disposed in a certain order within said respective color ball passages.

In the above described battery capacity chromogenic device, said supporting bracket comprises, in order from the bottom up, a pallet, a slide track bracket, and a locating sleeve which are integrally connected, said locating sleeve is fixedly provided on the lower end of each indicating bar and is provided thereon with opening holes corresponding to the indicating bars in number, the center line of each opening hole respectively approximately coincides with the center line of each indicating bar, between the upper end face and the lower end face of said slide track there are provided inclined through holes corresponding to the indicating bars in number, said base plate is provided with color ball locating slots corresponding to the indicating bars in number, and said respective color ball locating slots, through holes and opening holes are respectively correspondingly arranged to define said color ball passages.

In the above described battery capacity chromogenic device, said respective indicating bars are arranged uniformly in the circumferential direction.

In the above described battery capacity chromogenic device, said indicating bars are 5- 12 in number.

In the above described battery capacity chromogenic device, said respective indicating bars are arranged uniformly in a rectangular way.

By adopting the above described solution, the present utility model renders the following benefical effects: by disposing the color balls different in specific gravity below the plurality indicating bars in a certain order for a centralized indication, the current capacity of the battery is represented visually and accruately, thus, the user may decide whether it is needed to charge or add water based on the task to be accomplished, make judgement concerning the failure that the car cannot be started and avoid the break down of the electric car halfway, moreover, the battery capacity chromogenic device is compact in construction and convenient to operate.

### Brief Description of Drawings

Fig.1 is a perspective view of an embodiment;
Fig.2 is an exploded perspective view of the embodiment; and
Fig.3 is a perspective view in a different visual angle of the indicating bar shown in Fig.2.

### Best Mode for Carrying out the Invention

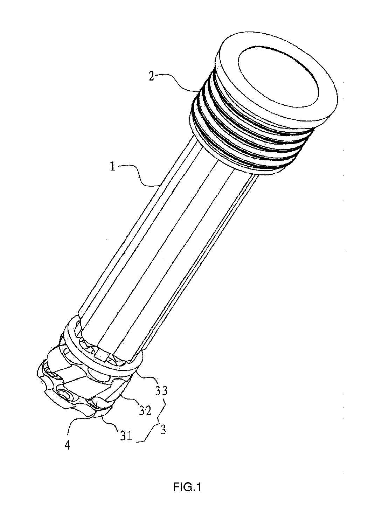

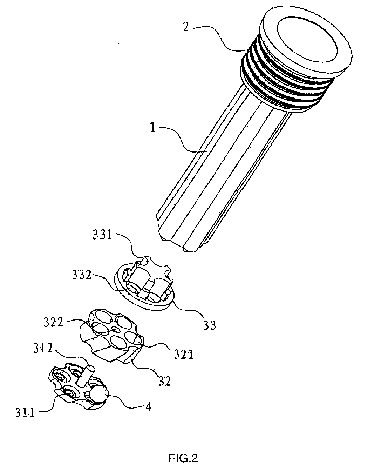

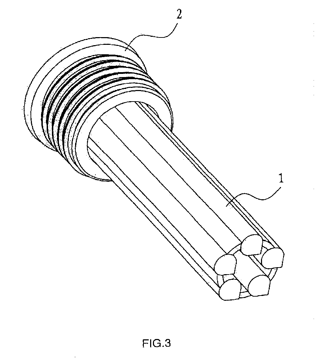

Referring to Figs. 1, 2, and 3, the present embodiment discloses a battery capacity chromogenic device, which comprises: five integrally formed indicating bars 1, fixing sleeves 2 each provided on the upper end of respective indicating bars 1, supporting brackets 3 each provided on the lower end of respective indicating bars 1, and five color balls 4 (only one is shown in the figures) with successively increased specific gravities, wherein, said five indicating bars 1 are integrally molded with the transparent PMMA plastic and are arranged uniformly in the circumferential direction, the lower ends of respective indicating bars 1 are provided with conical protrusions that are protruding outwardly, said fixing sleeve 2 is provided with a locating hole in the middle, the outside wall of the fixing sleeve 2 is provided with male threads, and the integrally molded indicating bars 1 are fixedly connected with the fixing sleeves through the locating holes such that the whole battery capacity chromogenic device is fastened onto the battery box cover via the male threads. Said supporting bracket 3 comprises, in order from the bottom up, a pallet 31, a slide track bracket 32, and a locating sleeve 33 which are integrally connected. Said locating sleeve 33 is provided with five pawls 331 on the side thereof adjacent to the respective indicating bar 1, through which five pawl 331, said locating sleeve 33 is embededly disposed below the respective indicating bar 1 and is fixedly connected ultrasonically. On the locating sleeve 33 there is provided five opening holes 332, the center line of each opening hole 332 respectively coincides with the center line of each indicating bar 1. Said slide track bracket 32 is substantially cylindrically structured, and between the upper and lower end faces thereof there are provided five inclined through holes 321. The slide track bracket 32 is provided with an fixing hole 322. Said pallet 31 is provided thereon with five color ball locating slots 311, the upper end face of the pallet 31 is in the middle provided with an upwardly extended locating post 312, said locating post 312 penetrates through the fixing hole 322 to finally connect

with the locating hole on the bottom of the locating sleeve 33 via interference fit, such that said pallet 31, slide track bracket 32, and locating sleeve 33 are integrally connected and are disposed below respective indicating bars 1. Said respective color ball locating slot 311, through hole 321 and opening hole 332 are respectively correspondingly arranged to define a color ball passage, and the vertical projection of the upper portion of respective color ball passage, that is, the opening hole 332, and the vertical projection of the lower portion thereof, that is, the color ball locating slot 311, on the same plane, are mutually staggered. Five color balls 4 with successively increased specific gravities ( only one is shown in the figures so as not to obscure the structure of the pallet 31) are respectively disposed with respective color ball passages. In the clockwise direction, from 0 to 360 degrees, the specific gravities of the five color balls 4 are successively increased. Accordingly, upon observation, in the clockwise direction, the larger the degree possessed by the color ball 4 that is floating, the greater the residual capacity of the battery is indicated, otherwise, the lower.

The above described embodiment mainly presents a battery capacity chromogenic device for visually indicating the battery capacity. Upon the inspiration of the conception of the present embodiment and on the basis of the same object of invention, those skilled in the art may increase the number of the indicating bars to 12 or even more. The respective indicating bars may be arranged uniformly in a circumferencial direction or in a rectangular way, while the color balls with successively varying specific gravities are disposed withn the respective color ball passages in a certain order. Thus, through observing the sinking and floating states of the color balls, the current capacity of the battery is visually known, and in combination with the actual operating environment, it is determined whether charging is needed or not. Meanwhile, the center lines of the opening holes on respective locating sleeves and of the indicating bars may be slightly offset from each other, which will not fundamentally affect the result of observation.

## Claims

1. A battery capacity chromogenic device, **characterized in that**, it comprises: a plurality of integrally formed indicating bars, fixing sleeves each provided on the upper end of respective indicating bars, supporting brackets each provided on the lower end of respective indicating bars, and color balls corresponding to the indicating bars in number, said supporting brackets are provided thereon with color ball passages corresponding to the indicating bars in number, said respective color ball passages are slantly disposed such that the vertical projections of the upper portions thereof and the vertical projections of the lower portions thereof are mutally staggered in the horizontal direction, and said respective color balls are increased in specific gravity successively and are respectively disposed in a certain order within said respective color ball passages.

2. The battery capacity chromogenic device according to claim 1, **characterized in that**: said supporting bracket comprises, in order from the bottom up, a pallet, a slide track bracket, and a locating sleeve which are integrally connected, said locating sleeve is fixedly provided on the lower end of each indicating bar and is provided thereon with opening holes corresponding to the indicating bars in number, the center line of each opening hole respectively approximately coincides with the center line of each indicating bar, between the upper end face and the lower end face of said slide track there are provided inclined through holes corresponding to the indicating bars in number, said base plate is provided with color ball locating slots corresponding to the indicating bars in number, and said respective color ball locating slots, through holes and opening holes are respectively correspondingly arranged to define said color ball passages.

3. The battery capacity chromogenic device according to claim 2, **characterized in that**: said respective indicating bars are arranged uniformly in the circumferential direction.

4. The battery capacity chromogenic device according to claim 3, **characterized in that**: said indicating bars are 5-12 in number.

5. The battery capacity chromogenic device according to claim 2, **characterized in that**: said respective indicating bars are arranged uniformly in a rectangular way.
